# EUROPEAN PATENT SPECIFICATION

(11) **EP 2 525 250 B1**
(45) Date of publication and mention of the grant of the patent: **18.02.2015**
(21) Application number: 12168545.7
(22) Date of filing: 18.05.2012
(51) Int. Cl.: G02F 1/1335, G02B 5/20

(54) **Color filter substrate and method of manufacturing the same**
Farbfiltersubstrat und Herstellungsverfahren dafür
Substrat de filtre coloré et son procédé de fabrication

(30) Priority: 19.05.2011 CN 201110130435
(43) Date of publication of application: 21.11.2012
(73) Proprietor: BOE Technology Group Co., Ltd., Beijing 100016 (CN)
(72) Inventor: Wang, Xuelan, 100176 Beijing (CN); Yang, Jiuxia, 1000176 Beijing (CN); Liu, Chen, 100176 Beijing (CN)
(74) Representative: Brötz, Helmut

(56) References cited:
- EP-A1- 0 854 169
- JP-A- 9 197 120
- JP-A- 2002 072 189
- JP-A- 2003 177 228
- JP-A- 2005 128 562
- JP-A- 2005 303 076
- JP-A- 2007 156 028
- US-A1- 2004 223 095

## Description

### BACKGROUND

The invention refers to a method of manufacturing a color filter substrate according to the preamble of claim 1. The disclosed technology relate to a color filter substrate and a method of manufacturing the same.

With development of the display technology, Thin Film Transistor Liquid Crystal Displays (TFT-LCDs) having superior properties such as high quality, low power consumption, non-radiation, etc. have become a mainstream of the market.

Currently, the liquid crystal displays are developing toward a direction to be full-color, large size, high resolution and low cost. The liquid crystal displays have to use a color filter to obtain an effect of color display. The color filter is generally disposed on a transparent glass substrate, i.e. a Black Matrix (BM) for shielding light and color filter layers (color film patterns) arranged in correspondence to individual pixels are disposed on the transparent glass substrate.

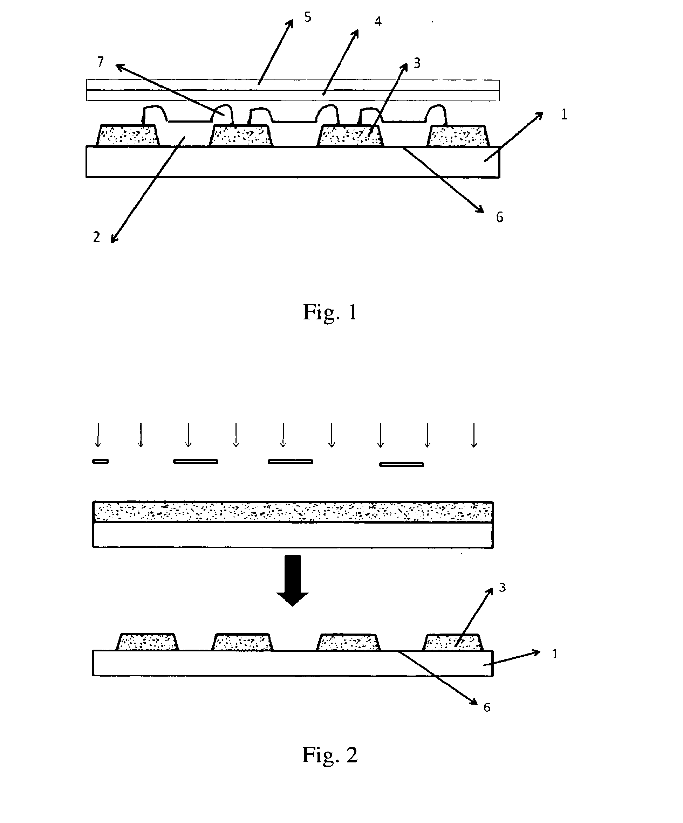

FIG.1 is a structural schematic view showing a color filter substrate in prior art. The color filter mainly includes: a base substrate 1, color filter layers 2, a black matrix 3, a transparent planarization layer 4 and a transparent conductive layer 5. There are a plurality of lattice points 6, which are defined by the black matrix, on the base substrate 1. The color filter layers 2 are disposed at the lattice points 6.

A manufacturing process of the color filter in prior art is: firstly, forming a black matrix pattern on a glass substrate, depositing color resins of three colors respectively, and next, forming the transparent planarization layer and the transparent conductive layer. In this course, four photolithography processes are performed and four different mask plates are used. The method specifically includes:

Step a: providing a base substrate 1, and forming a black matrix 3 on a surface of the base substrate 1, as specifically shown in FIG. 2;

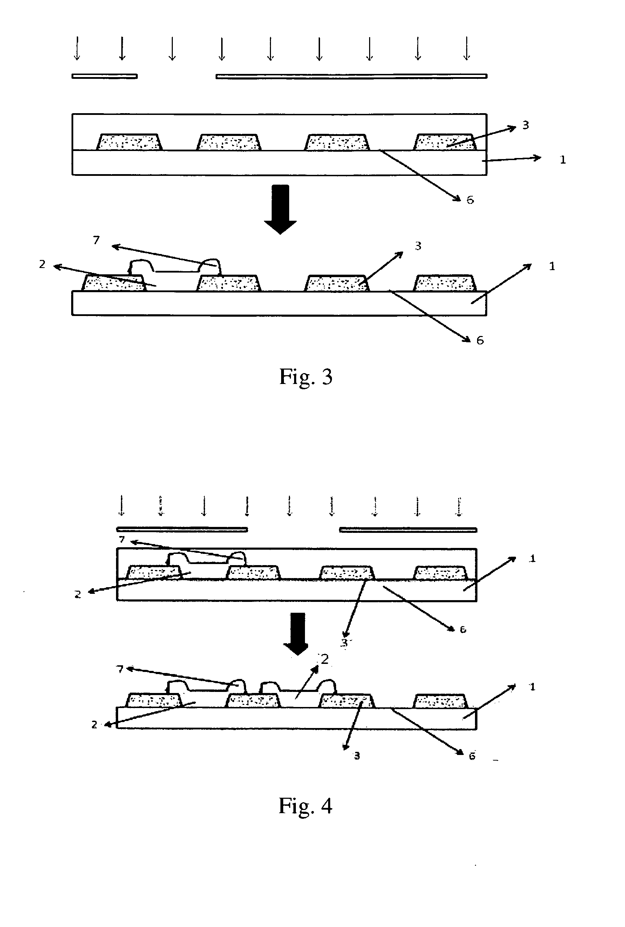

Step b: applying a color film at the lattice points 6 between the black matrix 3, and on the black matrix 3, and the applied color film is patterned by means of a front side exposure process, and then, forming a first color film pattern 2 by a development process, as specifically shown in FIG. 3;

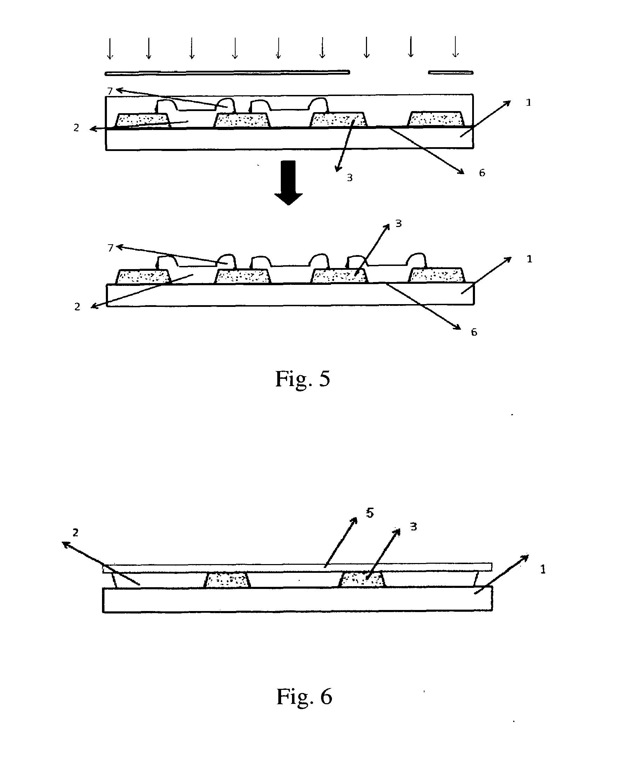

Step c: forming a second and a third color film patterns 2 respectively at the lattice points 6 on the black matrix 3 by using the same process as step b, as specifically shown in FIGs. 4 and 5,

The first, second and third color film patterns 2 are sequentially arranged within different lattice points 6;

Step d: forming a transparent planarization layer 4 and a transparent conductive layer 5 on surfaces of the first, second and third color film patterns 2 so as to obtain the color filter substrate as shown in FIG. 1.

To give the color filter substrate good optical properties during the manufacturing process of the color filter, there is generally a partial overlay, i.e. a corner step, between the color film patterns 2 and the black matrix 3. A bump 7 may be formed in an overlay region of the color film patterns 2 and the black matrix 3 formed by the front side exposure, thereby causing the corner step of the color filter layers 2. The corner step may exert an influence on coating of an alignment layer, a rubbing effect and even alignment of liquid crystals, so as to have an effect on the display quality of picture of the product. Therefore, it is essential that a relatively planar surface is to be produced. In general, deposition of the transparent planarization layer 4 will make the whole surface of the color filter layers 2 planar.

However, the manufacture of the color filter substrate by using the above conventional process may suffer from the following drawbacks:

Although the transparent planarization layer 4 is deposited on the surfaces of the color filter layers, the corner step of the color filter layers 2 is still present, which may still affect quality of the color filter substrate. Thus, display quality of the color filter substrate is degraded to a certain degree. It is necessary for the conventional process of manufacturing the color filter substrate that four mask plates are used and the transparent planarization layer 5 is deposited, thereby increasing the production cost. JP 2005303076A discloses a method of manufacturing a color filter substrate in which color film patterns are formed by exposure at a front side and a black matrix is formed by exposure at a back side. JP 9197120A discloses a method of manufacturing a color filter in which a black matrix is formed by using a back exposure method. US 2004/223095 discloses that color filters may have a normal tapered shape or an inverse tapered shape. JP 2005 128562 A discloses a method for manufacturing a color filter composed of the pixel and either the black matrix or the pixels, the film thickness of these component members are almost the same. JP 2002 072189 A discloses a substrate including a coloring layer comprising three primary colors and a black matrix, and shows a coloring layer with a cross-sectional shape of inverted trapezoidal in the drawings. JP 2007 156028 A discloses a color filter of inverted trapezoidal cross-section.

### SUMMARY

According to the subject matter of claim 1, there is provided a method of manufacturing a color filter substrate comprising: preparing a transparent base substrate, the transparent base substrate having a first principal surface and a second principal surface opposite to the first principal surface; forming a color film on the first principal surface of the transparent base substrate, performing an exposure on the color film by illuminating light through a mask plate, and etching the exposed color film to form a plurality of color film patterns, the plurality of color film patterns having intervals therebetween; and forming a black matrix in the intervals between the plurality of color film patterns so that the black matrix fully fill the intervals between the plurality of color film patterns, wherein the step of forming the black matrix comprises: forming a film for the black matrix on the first principal surface of the transparent base substrate with the plurality of color film patterns formed thereon, performing an exposure on the film for the black matrix by illuminating light from the second principal surface side of the transparent base substrate, and etching the exposed film for the black matrix to form the black matrix, and wherein the color film is exposed by illuminating light from the second principal surface side of the transparent base substrate through the mask plate, and a cross section of each color film pattern taken along a direction perpendicular to the surface of the transparent base substrate has a shape of an inverted isosceles trapezoid.

Preferred embodiments are provided by the subject matter of the dependent claims.

Further scope of applicability of the disclosed technology will become apparent from the detailed description given hereinafter. However, it should be understood that the detailed description and specific examples, while indicating preferred embodiments of the disclosed technology, are given by way of illustration only, since various changes and modifications within the scope of the appended claims will become apparent to those skilled in the art from the following detailed description.

### BRIEF DESCRIPTION OF THE DRAWINGS

The disclosed technology will become more fully understood from the detailed description given hereinafter and the accompanying drawings which are given by way of illustration only, and thus are not limitative of the disclosed technology and wherein:
FIG.1 is a structural schematic view showing a color filter substrate in prior art;
FIG.2 is a schematic view showing a process in which a black matrix is manufactured by a front side exposure in prior art;
FIG.3 is a schematic view showing a process in which a first color film pattern is manufactured by a front side exposure in prior art;
FIG.4 is a schematic view showing a process in which a second color film pattern is manufactured by a front side exposure in prior art;
FIG.5 is a schematic view showing a process in which a third color film pattern is manufactured by a front side exposure in prior art;
FIG.6 is a structural schematic view showing a color filter substrate fabricated according to an embodiment of the disclosed technology;
FIG.7 is a structural schematic view showing a process in which a first color film pattern is manufactured by a back side exposure according to an embodiment of the disclosed technology;
FIG.8 is a structural schematic view showing a process in which a second color film pattern is manufactured by a back side exposure according to an embodiment of the disclosed technology;
FIG.9 is a structural schematic view showing a process in which a third color film pattern is manufactured by a back side exposure according to an embodiment of the disclosed technology;
FIG. 10 is a structural schematic view showing a process in which a black matrix are manufactured by back side exposure according to an embodiment of the disclosed technology; and
FIG. 11 is a comparatively schematic view showing an opening portion of a color filter substrate manufactured in prior art and an opening portion of a color filter substrate manufactured according to an embodiment of the disclosed technology.

### DETAILED DESCRIPTION

Embodiments of the disclosed technology now will be described more clearly and fully hereinafter with reference to the accompanying drawings, in which the embodiments of the disclosed technology are shown.

For improving display quality of a color filter substrate and decreasing production cost thereof, a color filter substrate and a method of manufacturing the same are provided according to embodiments of the disclosed technology. As shown in FIG. 6, in a process of manufacturing the color filter substrate, a plurality of color film patterns 2 are formed on a base substrate 1 firstly by means of back side exposure, and then a black matrix 3 is formed on the substrate between the color film patterns by means of back side exposure. Therefore, a problem that display quality of the color filter substrate is degraded, due to a corner step occurring at an overlay position of color film patterns and a black matrix formed by means of front side exposure during the conventional manufacture of a color filter substrate, is solved. Further, a problem that production cost is relatively high due to utilizing four mask plates during the conventional manufacture of the color filter substrate is solved.

Hereinafter, embodiments according to the disclosed technology will be described in detail with reference to the accompanied drawings.

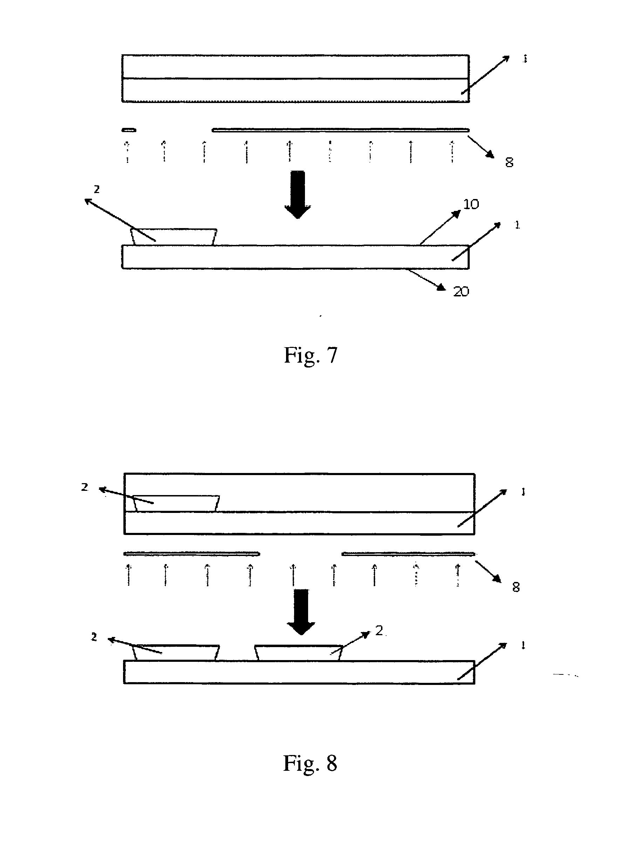

Referring to FIGs. 7-10, in an embodiment according to the disclosed technology, a process of manufacturing a color filter substrate is as follows:

Step 700: forming a plurality of color film patterns 2 on a transparent base substrate (e.g., glass substrate) by means of back side exposure, the plurality of color film patterns 2 having intervals 6 therebetween to expose a surface of the substrate or an underlying layer of the color film patterns. The transparent base substrate has a first principal surface 10 and a second principal surface 20 opposite to the first principal surface 10 (as shown in FIG. 7). The plurality of color film patterns 2 are formed on the first principal surface.

In the course of performing the step 700, for example, individual color film patterns 2 can have the same thickness by means of adjusting the process (such as, adjusting a thickness of an initially formed color film, an exposure intensity and an etching rate, etc.), so that a top surface of each of the color film patterns 2 is in the same plane.

In the embodiment, step 700 comprises: applying a color film on the first principal surface 10 of the base substrate 1, performing a back side exposure on the substrate (i.e., light is illuminated from the second principal surface 20 side of the base substrate 1) via a mask plate 8 with UV light, and forming a first color film pattern 2, a second color film pattern 2, a third color film pattern 2 through an etching process. The step 700 will be described in more detail below.

At first, as shown in FIG. 7, a color film (in a first color, for example) is coated on the first principal surface 10 of the base substrate 1, the base substrate 1 is subjected to a back side exposure (i.e., light is illuminated from the second principal surface 20 side of the base substrate 1) via a mask plate 8 with UV light, and the first color film pattern 2 is formed on the color film through the etching process. After the color film is coated and before the back side exposure is performed, for example, a pre-baking may be conducted on the color film. During the etching process, for example, an alkaline developer can be used for etching; and further, a high-pressure water rinse and a main baking can be performed on the first color film pattern 2 after formation thereof.

As shown in FIG. 7, in this course, a mask plate is used for the first time. A cross section of the finally formed first color film pattern 2 taken along a direction perpendicular to a surface of the substrate has a shape of inverted isosceles trapezoid. That is, a top width of the first color film pattern 2 is larger than a bottom width thereof.

Next, as shown in FIG. 8, a color film (in a second color, for example) is coated on the first principal surface 10 of the base substrate 1, the base substrate 1 is subjected to a back side exposure (i.e., light is illuminated from the second principal surface 20 side of the base substrate 1) via a mask plate 8 with UV light, and the second color film pattern 2 is formed through an etching process. After the color film is coated and before the back side exposure is performed, for example, a pre-baking may be conducted on the color film. During the etching process, for example, an alkaline developer can be used for etching; and further, a high-pressure water rinse and a main baking can be performed on the second color film pattern 2 after formation thereof.

As shown in FIG. 8, in this course, the mask plate is used for the second time. A cross section of the finally formed second color film pattern 2 taken along the direction perpendicular to the surface of the substrate has a shape of inverted isosceles trapezoid. That is, a top width of the second color film pattern 2 is larger than a bottom width thereof. The height and shape of the second color film pattern are the same as those of the first color film pattern 2.

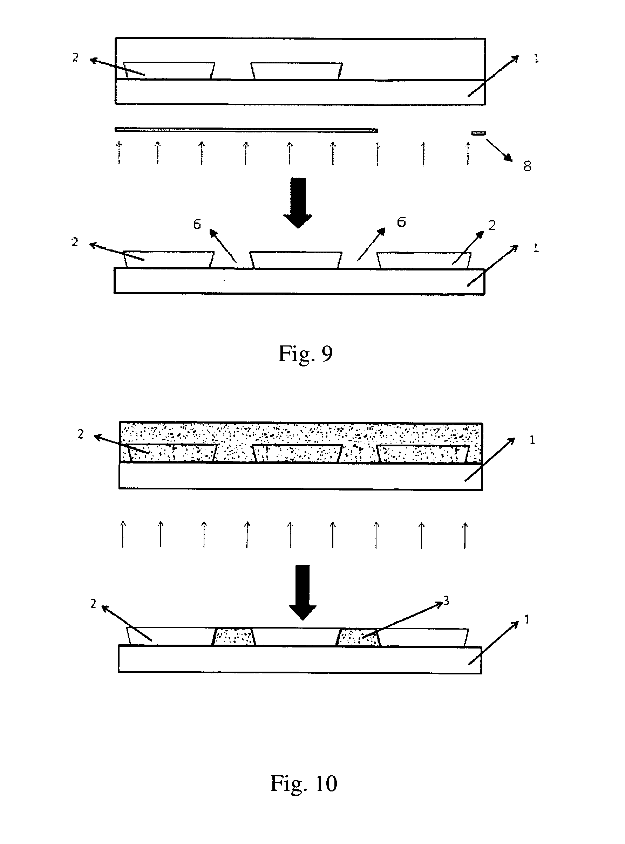

Finally, as shown in FIG. 9, a color film (in a third color, for example) is coated on the first principal surface 10 of the base substrate 1, the base substrate 1 is subjected to a back side exposure (i.e., light is illuminated from the second principal surface 20 side of the base substrate 1) via a mask plate 8 with UV light, and the third color film pattern 2 is formed through an etching process. After the color film is coated and before the back side exposure is performed, for example, a pre-baking may be conducted on the color film. During the etching process, for example, an alkaline developer can be used for etching; and further, a high-pressure water rinse and a primary baking can be performed on the third color film pattern 2 after formation thereof.

As shown in FIG. 9, in this course, the mask plate is used for the third time. A cross section of the finally formed third color film pattern 2 taken along the direction perpendicular to the surface of the substrate has a shape of inverted isosceles trapezoid. That is, a top width of the third color film pattern 2 is larger than a bottom width thereof. The height and shape of the third color film pattern 2 are the same as those of the first color film pattern 2 and the second color film pattern 2.

The resultant first, second and third color film patterns 2 have intervals 6 therebetween (as shown in FIG. 9). The first, second and third colors can be different colors. For instance, they are red, green and blue, respectively, but the disclosed technology is not limited thereto. Further, the disclosed technology is not limited to color film patterns in three different colors. Rather, color film patterns in two, four or more different colors can also be formed.

In the course of the formation of the first color film pattern 2, the second color film pattern 2, and the third color film pattern 2, it is preferably to make sure that the first color film pattern 2, the second color film pattern 2, and the third color film pattern 2 have the same thickness, and their top surfaces are in the same plane, so as to avoid or decrease a step between the first color film pattern 2, the second color film pattern 2, and the third color film pattern 2. The first color film pattern 2, the second color film pattern 2, and the third color film pattern 2 have intervals 6 therebetween so as to expose a surface of the substrate or an underlying layer.

Step 710: filling material for a black matrix in the intervals 6 between each of the color film patterns to form a black matrix 3, such that the black matrix 3 closely adjoins an adjacent color film 2. That is, the black matrix 3 fully fills the intervals 6 between the above color film patterns.

In the course of performing the step 710, for example, the top surfaces of the black matrix 3 and each of the color film patterns 2 can be in the same plane by means of adjusting the process (such as, adjusting a thickness of an initially formed material for the black matrix, an exposure intensity and an etching rate, etc.), so that the top surfaces of the black matrix 3 and the color film patterns 2 can achieve a perfect planarization.

In the embodiment, the manufacturing process for the black matrix 3 and the manufacturing process for the color film patterns 2 are substantially the same. That is, a film for the black matrix is formed on the first principal surface 10 of the base substrate 1 with the above color film patterns 2 formed thereon, and the black matrix 3 is formed through a back side exposure (i.e., light is illuminated from the second principal surface 20 side of the base substrate 1) and an etching. The difference lies in that, no mask plate is needed during the back side exposure upon formation of the black matrices, but the formerly formed first color film pattern 2, the second color film pattern 2 and the third color film pattern 2 are used as a mask for performing the back side exposure on the deposited film for the black matrix. As such, a number of the mask plate to be used is decreased, the production cost of the process is saved to a certain extent and the production efficiency is improved. Meanwhile, because the first color film pattern 2, the second color film pattern 2 and the third color film pattern 2 are used as a mask plate, it is unnecessary to precisely align the black matrix layer with the first color film pattern 2, the second color film pattern 2 and the third color film pattern 2. A corresponding pattern of the black matrix 3 can be directly formed according to the shape of the intervals 6 between individual color film patterns 2, thereby simplifying the process. The step is described in further details as follows:

As shown in FIG. 10, a black matrix layer is coated on the substrate 1, a back side exposure is performed on the black matrix layer using the first, second and third color film patterns 2 as a mask with UV light, and the black matrix layer at each of the intervals 6 remains through an etching process so as to form the black matrix 3. After the black matrix layer is coated and before the back side exposure is performed, for example, a pre-baking may be conducted on the black matrix material layer. During the etching process, for instance, an alkaline developer can be used for etching. Further, after the black matrix layer at each of the intervals 6 is formed to be the black matrix 3, for example, a high-pressure water rinse and a main baking may be conducted on it. For example, material for the black matrix 3 is a light shielding resin or a metal of Chrome (Cr).

In the course of forming a black matrix 3, it is necessary to make sure that the black matrix 3 closely adjoins a color film pattern 2 next to it (i.e., the black matrix 3 fully fills the intervals 6 between the color film patterns). In addition, it is preferable that the black matrix 3 and each of the color film patterns 2 have the same thickness and top surfaces thereof are in the same plane. As shown in FIG. 10, through this process, the black matrix 3 and the first color film pattern 2, the second color film pattern 2 and the third color film pattern 2 closely adjoin each other and do not have an overlay therebetween. That is, no corner step may be formed on the black matrix 3 by each of the color film patterns 2. Thus, the display quality of picture of the final product can be efficiently improved and the yield can be enhanced. Furthermore, top surfaces of the black matrix 3 and each of the color film patterns 2 have already been planarized through the above process, and thus it is unnecessary to additionally apply a transparent planarization layer for planarization. Thereby, the production time and the production cost are further efficiently saved.

Based on the above embodiment, as shown in FIG. 6, at last, a transparent conductive layer 5 is sputtered on the top surfaces of the black matrix 3 and each of the color film patterns 2, thereby completing a final color filter substrate.

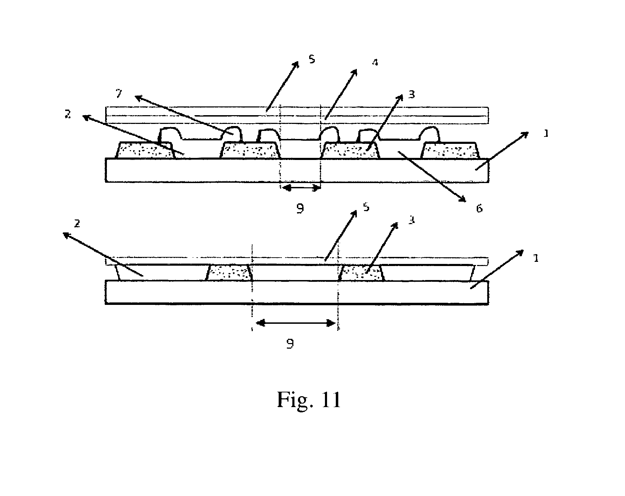

As shown in FIG. 11, compared to a color filter formed in prior art, a pixel opening portion 9 for the color filter substrate formed in accordance with an embodiment of the disclosed technology is largely increased. As such, display quality of picture of the final product can be remarkably improved, and further the yield is enhanced.

Based on the above embodiment, as shown in FIGs. 6 and 12, the structure of a color filter substrate produced through a process provided by an embodiment of the disclosed technology comprises:

a transparent base substrate 1;

a plurality of color film patterns 2 disposed on the transparent base substrate 1, each of the color film patterns 2 having intervals 6 therebetween; and

a black matrix 3 disposed at the intervals between the color film patterns 2, the black matrix 3 closely adjoins an adjacent color film 2 (i.e., the black matrix 3 fully fills intervals 6 between the plurality of color film patterns 2).

As shown in FIGs. 6 and 11, the color filter substrate further comprises a transparent conductive layer 5 directly disposed on top surfaces of the black matrix 3 and each of the color film pattern 2.

For instance, each of the color film patterns 2 has the same thickness and an top surface thereof is in the same plane, and the black matrices 3 and each of the color film patterns 2 have the same thickness and top surfaces thereof are in the same plane.

A cross section of the color film patterns 2 taken along a direction perpendicular to a surface of the base substrate can be in an inverted isosceles trapezoid shape. A top width of each of the color film patterns 2 is larger than a bottom width thereof. That is, the width of each of the color film patterns 2 is gradually increased from a side of the color film pattern 2 adjacent to the base substrate 1 to a side of the color film pattern 2 far from the base substrate 1. Material for the black matrix 3 is a light shielding resin or a metal of Chrome (Cr).

In an embodiment of the disclosed technology, during the production process of the color filter substrate, the plurality of color film patterns 2 are formed on the base substrate 1 by means of back side exposure, and there are intervals 6 between each of the color film patterns 2 to expose the base substrate or an underlying layer. Next, a black matrix 3 is formed at each of the intervals 6 by means of back side exposure, such that the black matrix 3 closely adjoins an adjacent color film pattern 2. As such, as top surfaces of the black matrix 3 and each of the color film patterns 2 are planarized, it is unnecessary to coat a transparent planarization layer, thereby effectively saving the production time and the production cost. Furthermore, the black matrix 3 and each of the color film patterns are formed by means of back side exposure during the production, and a number of the mask plate to be used is decrease. Thus, the production cost is further remarkably saved and the yield is enhanced. On the other hand, because top surfaces of each of the black matrices 3 and each of the color film patterns 2 are planarized, there is no longer a corner step therebetween, thereby improving the display quality of picture of the final product and enhancing the yield of the product.

It should be noted that the above embodiments only have the purpose of illustrating the disclosed technology, but not limiting it. Although the disclosed technology has been described with reference to the above embodiment, those skilled in the art should understand that modifications can be made to the described embodiments without departing from the scope of the appended claims.

## Claims

1. A method of manufacturing a color filter substrate, comprising:
preparing a transparent base substrate (1), the transparent base substrate (1) having a first principal surface (10) and a second principal surface (20) opposite to the first principal surface (10);
forming a color film on the first principal surface (10) of the transparent base substrate (1), performing an exposure on the color film by illuminating light through a mask plate (8), and etching the exposed color film to form a plurality of color film patterns (2), the plurality of color film patterns (2) having intervals (6) therebetween; and
forming a black matrix (3) in the intervals (6) between the plurality of color film patterns (2) so that the black matrix (3) fully fills the intervals (6) between the plurality of color film patterns (2),
wherein the step of forming the black matrix (3) comprises: forming a film for the black matrix on the first principal surface (10) of the transparent base substrate (1) with the plurality of color film patterns (2) formed thereon, performing an exposure on the film for the black matrix by illuminating light from the second principal surface (20) side of the transparent base substrate (1), and etching the exposed film for the black matrix to form the black matrix (3),
**characterized in that**
the color film is exposed by illuminating light from the second principal surface (20) side of the transparent base substrate (1) through the mask plate (8), and
a cross section of each color film pattern (2) taken along a direction perpendicular to the surface of the transparent base substrate (1) has a shape of an inverted isosceles trapezoid.

2. The method of claim 1, wherein during exposure of the film for the black matrix, the plurality of color film patterns (2) are used as a mask.

3. The method of claim 1 or 2, wherein the thickness of each of the plurality of color film patterns (2) is formed to be the same as the thickness of the black matrix (3), and top surfaces of the plurality color film patterns (2) and a top surface of the black matrix (3) are in the same plane.

4. The method of any of claims 1-3, wherein during exposure of the color film, the exposure is performed by illuminating an UV light from the second principal surface (20) of the transparent base substrate (1) via the mask plate (8).

5. The method of any of claims 1-4, wherein the plurality of color film patterns (2) include a color film pattern in a first color, a color film pattern in a second color and a color film pattern in a third color.

6. The method of any of claims 1-5, wherein the step of forming the plurality of color film patterns (2) comprises:
forming a color film in a first color on the first principal surface (10) of the transparent base substrate (1), performing an exposure on the color film in the first color by illuminating light from the second principal surface (20) side of the transparent base substrate (1), and etching the exposed color film in the first color to form a color film pattern in the first color;
forming a color film in a second color on the first principal surface (10) of the transparent base substrate (1), performing an exposure on the color film in the second color by illuminating light from the second principal surface (20) side of the transparent base substrate (1), and etching the exposed color film in the second color to form a color film pattern in the second color; and
forming a color film in a third color on the first principal surface (10) of the transparent base substrate (1), performing an exposure on the color film in the third color by illuminating light from the second principal surface (20) side of the transparent base substrate (1), and etching the exposed color film in the third color to form a color film pattern in the third color.

7. The method of any of claims 1-6, wherein a top width of each color film pattern (2) is larger than a bottom width of the color film pattern (2).

8. The method of any of claims 1-7, wherein the material for the black matrix (3) is a light shielding resin.

9. The method of any of claims 1-8, further comprising: after forming the plurality of color film patterns (2) and the black matrix (3), depositing a transparent conductive layer (5) on top surfaces of the black matrix (3) and the plurality of color film patterns (2) by a sputtering process.

## Patentansprüche

1. Verfahren zur Herstellung eines Farbfiltersubstrats, umfassend:
Präparieren eines transparenten Basissubstrats (1), wobei das transparente Basissubstrat (1) eine erste Hauptoberfläche (10) und eine zweite Hauptoberfläche (20) auf der zu der ersten Hauptoberfläche (10) entgegengesetzten Seite aufweist;
Bilden eines Farbfilms auf der ersten Hauptoberfläche (10) des transparenten Basissubstrats (1),
Durchführen einer Belichtung des Farbfilms mittels Leuchten von Licht durch eine Maskenplatte (8), und Ätzen des belichteten Farbfilms, um eine Mehrzahl von Farbfilmmustern (2) zu bilden, wobei die Mehrzahl der Farbfilmmuster (2) zwischen sich Intervalle (6) aufweist; und
Bilden einer schwarzen Matrix (3) in den Intervallen (6) zwischen der Mehrzahl der Farbfilmmuster (2), so dass die schwarze Matrix (3) die Intervalle (6) zwischen der Mehrzahl der Farbfilmmuster (2) vollständig füllt,
wobei der Schritt des Bildens der schwarzen Matrix (3) umfasst: Bilden eines Films für die schwarze Matrix auf der ersten Hauptoberfläche (10) des transparenten Basissubstrats (1) mit der Mehrzahl der darauf gebildeten Farbfilmmuster (2), Durchführen einer Belichtung auf dem Film für die schwarze Matrix mittels Leuchten von Licht von der Seite der zweiten Hauptoberfläche (20) des transparenten Basissubstrats (1), und Ätzen des belichteten Films für die schwarze Matrix, um die schwarze Matrix (3) zu bilden,
**dadurch gekennzeichnet, dass**
der Farbfilm belichtet wird mittels Leuchten von Licht von der Seite der zweiten Hauptoberfläche (20) des transparenten Basissubstrats (1) durch die Maskenplatte (8), und
dass ein Querschnitt von jedem Farbfilmmuster (2) entlang einer zu der Oberfläche des transparenten Basissubstrats (1) senkrechten Richtung eine Gestalt eines umgekehrten gleichschenkeligen Trapezes aufweist.

2. Verfahren gemäß Anspruch 1, wobei während der Belichtung des Films für die schwarze Matrix die Mehrzahl der Farbfilmmuster (2) als eine Maske verwendet wird.

3. Verfahren gemäß Anspruch 1 oder 2, wobei die Dicke von jedem Farbfilmmuster (2) aus der Mehrzahl der Farbfilmmuster (2) gleich groß wie die Dicke der schwarzen Matrix (3) gebildet wird und wobei die oberen Oberflächen der Mehrzahl der Farbfilmmuster (2) und eine obere Oberfläche der schwarzen Matrix (3) in der gleichen Ebene liegen.

4. Verfahren gemäß einem der Ansprüche 1 bis 3, wobei während der Belichtung des Farbfilmes die Belichtung durchgeführt wird mittels Leuchten eines UV-Lichts von der zweiten Hauptoberfläche (20) des transparenten Basissubstrats mittels der Maskenplatte (8).

5. Verfahren gemäß einem der Ansprüche 1 bis 4, wobei die Mehrzahl der Farbfilmmuster (2) ein Farbfilmmuster in einer ersten Farbe, ein Farbfilmmuster in einer zweiten Farbe und ein Farbfilmmuster in einer dritten Farbe enthält.

6. Verfahren gemäß einem der Ansprüche 1 bis 5, wobei der Schritt des Bildens der Mehrzahl von Farbfilmmustern (2) umfasst:
Bilden eines Farbfilms in einer ersten Farbe auf der ersten Hauptoberfläche (10) des transparenten Basissubstrats (1), Durchführen einer Belichtung auf dem Farbfilm in der ersten Farbe mittels Leuchten von Licht von der Seite der zweiten Hauptoberfläche (20) des transparenten Basissubstrats (1) und Ätzen des belichteten Farbfilms in der ersten Farbe, um ein Farbfilmmuster in der ersten Farbe zu bilden;
Bilden eines Farbfilms in einer zweiten Farbe auf der ersten Hauptoberfläche (10) des transparenten Basissubstrats (1), Durchführen einer Belichtung auf dem Farbfilm in der zweiten Farbe mittels Leuchten von Licht von der Seite der zweiten Hauptoberfläche (20) des transparenten Basissubstrats (1), und Ätzen des belichteten Farbfilms in der zweiten Farbe, um ein Farbfilmmuster in der zweiten Farbe zu bilden; und
Bilden eines Farbfilms in einer dritten Farbe auf der ersten Hauptoberfläche (10) des transparenten Basissubstrats (1), Durchführen einer Belichtung auf dem Farbfilm in der dritten Farbe mittels Leuchten von Licht von der Seite der zweiten Hauptoberfläche (20) des transparenten Basissubstrats (1), und Ätzen des belichteten Farbfilms in der dritten Farbe, um ein Farbfilmmuster in der dritten Farbe zu bilden.

7. Verfahren gemäß einem der Ansprüche 1 bis 6, wobei eine obere Breite von jedem Farbfilmmuster (2) größer ist als eine untere Breite des Farbfilmmusters (2).

8. Verfahren gemäß einem der Ansprüche 1 bis 7, wobei das Material für die schwarze Matrix (3) ein Licht abschirmendes Harz ist.

9. Verfahren gemäß einem der Ansprüche 1 bis 8, weiter umfassend:
Nach dem Bilden der Mehrzahl von Farbfilmmustern (2) und der schwarzen Matrix (3), Abscheiden einer transparenten leitfähigen Lage (5) auf oberen Oberflächen der schwarzen Matrix (3) und der Mehrzahl von Farbfilmmustern (2) mittels eines Bedampfungsprozesses.

## Revendications

1. Procédé de fabrication d'un substrat de filtre de couleur, comprenant :
la préparation d'un substrat de base transparent (1), le substrat de base transparent (1) ayant une première surface principale (10) et une seconde surface principale (20) opposée à la première surface principale (10);
la formation d'un film de couleur sur la première surface principale (10) du substrat de base transparent (1), effectuer une exposition sur le film de couleur par une lumière éclairante à travers une plaque de masque (8), et graver le film de couleur exposé pour former une pluralité de motifs de film de couleur (2), la pluralité de motifs de film de couleur (2) ayant des intervalles (6) entre eux ; et
la formation d'une matrice noire (3) dans les intervalles (6) entre la pluralité de motifs de film de couleur (2), de sorte que la matrice noire (3) remplit complètement les intervalles (6) entre la pluralité de motifs de film de couleur (2),
dans lequel l'étape de formation de la matrice noire (3) comprend : la formation d'un film pour la matrice noire sur la première surface principale (10) du substrat de base transparent (1) avec la pluralité de motifs de film de couleur (2) formés sur celle-ci, effectuer une exposition sur le film pour la matrice noire par une lumière éclairante provenant de la seconde surface principale (20) du substrat de base transparent (1), et graver le film exposé pour la matrice noire pour former la matrice noire (3),
**caractérisé en ce que**
le film de couleur est exposé par une lumière éclairante provenant de la seconde surface principale (20) du substrat de base transparent (1) à travers une plaque de masque (8), et **en ce que**
une section transversale de chaque motif de film de couleur (2) selon une direction perpendiculaire à la surface du substrat de base transparent (1) a la forme d'un trapèze isocèle inversé.

2. Procédé selon la revendication 1, **caractérisé en ce que** au cours de l'exposition du film pour la matrice noire, la pluralité des motifs de film de couleur (2) sont utilisés en tant que masque.

3. Procédé selon la revendication 1 ou 2, **caractérisé en ce que** l'épaisseur de chaque pluralité de motifs de film de couleur (2) est formée pour être la même que l'épaisseur de la matrice noire (3), et **en ce que** les surfaces supérieures de la pluralité de motifs de film de couleur (2) et une surface supérieure de la matrice noire (3) sont dans le même plan.

4. Procédé selon l'une des revendications 1 à 3, **caractérisé en ce que** au cours de l'exposition du film de couleur, l'exposition est réalisée par une lumière éclairante UV provenant de la seconde surface principale (20) du substrat de base transparent (1) par l'intermédiaire de la plaque de masque (8).

5. Procédé selon l'une des revendications 1 à 4, **caractérisé en ce que** la pluralité de motifs de film de couleur (2) comprend un motif de film de couleur dans une première couleur, un motif de film de couleur dans une deuxième couleur et un motif de film de couleur dans une troisième couleur.

6. Procédé selon l'une des revendications 1 à 5, **caractérisé en ce que** l'étape de formation de la pluralité de motifs de film de couleur (2) comprend:
la formation d'un film de couleur dans une première couleur sur la première surface principale (10) du substrat de base transparent (1), effectuer une exposition sur le film de couleur dans la première couleur par une lumière éclairante provenant de la seconde surface principale (20) côté du substrat de base transparent (1), et graver le film de couleur exposé dans la première couleur afin de former un motif de film de couleur dans la première couleur;
la formation d'un film de couleur dans une deuxième couleur sur la première surface principale (10) du substrat de base transparent (1), effectuer une exposition sur le film de couleur à la deuxième couleur par une lumière éclairante provenant de la seconde surface principale (20) du substrat de base transparent (1), et graver le film de couleur exposé dans la deuxième couleur pour former un motif de film en couleurs dans la deuxième couleur; et
la formation d'un film de couleur dans une troisième couleur sur la première surface principale (10) du substrat de base transparent (1), effectuer une exposition sur le film de couleur à la troisième couleur par une lumière éclairante provenant de la seconde surface principale (20) côté du substrat de base transparent (1), et graver le film de couleur exposé dans la troisième couleur pour former un motif de film en couleurs dans la troisième couleur.

7. Procédé selon l'une des revendications 1 à 6, **caractérisé en ce que** la largeur du haut de chaque motif de film de couleur (2) est supérieure à la largeur du bas des motifs de film de couleur (2).

8. Procédé selon l'une des revendications 1 à 7, **caractérisé en ce que** le matériau pour la matrice noire (3) est une résine de protection contre la lumière.

9. Procédé selon l'une des revendications 1 à 8, comprenant en outre : après la formation de la pluralité de motifs de film de couleur (2) et de la matrice noire (3), le dépôt d'une couche conductrice transparente (5) sur les surfaces supérieures de la matrice noire (3) et de la pluralité de motifs de film de couleur (2) par un procédé de pulvérisation cathodique.
